Europäisches Patentamt

European Patent Office

Office européen des brevets

(19)

(11) Veröffentlichungsnummer: **0 032 746**
A1

# (12) EUROPÄISCHE PATENTANMELDUNG

(21) Anmeldenummer: 81100379.7

(22) Anmeldetag: 20.01.81

(51) Int. Cl.³: **H 03 K 19/003**, H 03 K 19/20

(30) Priorität: 22.01.80 JP 5307/80

(43) Veröffentlichungstag der Anmeldung: **29.07.81**
Patentblatt 81/30

(84) Benannte Vertragsstaaten: **CH DE FR GB IT LI**

(71) Anmelder: **YAMATAKE-HONEYWELL CO.LTD., 2-12-19, Shibuya-Ku, Tokyo 150 (JP)**

(72) Erfinder: **Yamamoto, Yuji, 8-19, Higashi-Kaigan, 2-chome, Tsujido, Fujisawa-city, Kanagawa (JP)**

(74) Vertreter: **Rentzsch, Heinz et al, Honeywell Europe S.A. Holding KG Kaiserieistrasse 55, D-6050 Offenbach am Main (DE)**

(54) **Logikschaltkreis.**

(57) Ein Logikschaltkreis zur Verknüpfung mehrerer Eingangssignale (E1 bis E4) und zur Abgabe eines Ausgangssignals (A) aufgrund der verknüpften Eingangssignale (E1 bis E4) besteht aus mehreren hintereinander geschalteten von jeweils einem Eingangssignal und von einer vorangehenden Schaltstufe beaufschlagten Schaltstufen (S1 bis S4), die in Abhängigkeit von ihrer Beaufschlagung einen kurzgeschlossenen oder offenen Ausgang aufweisen. Der Logikschaltkreis führt je nach Aufbau eine UND- oder NAND-Verknüpfung der Eingangssignale (E1 bis E4) aus, wobei der Ausgang A bei Auftreten bestimmter Fehler in der Schaltung in den kurzgeschlossenen Zustand geht.

0032746

YAMATAKE-HONEYWELL Co. Ltd.
2-12-19, Shibuya, Shibuya-Ku
Tokyo 150, Japan

19. Januar 1981
9805075 EP
Hz/de

Logikschaltkreis

Die vorliegende Erfindung betrifft einen Logikschaltkreis nach dem Gattungsbegriff des Anspruches 1. Bei bekannten Logikschaltkreisen dieser Art werden die zu verknüpfenden Eingangssignale parallel über Widerstände einer Eingangsstufe zugeführt. Wenn einer der Widerstände defekt wird, so kann dieser Logikschaltkreis seine Funktion in bestimmten Fällen nicht mehr erfüllen.

Es ist daher die Aufgabe der vorliegenden Erfindung, einen Logikschaltkreis der eingangs genannten Art so aufzubauen, daß auch bei einem defekten Widerstand die Funktion des Logikschaltkreises gewährleistet bleibt. Die Lösung dieser Aufgabe gelingt gemäß der im Anspruch 1 gekennzeichneten Erfindung. Weitere vorteilhafte Ausgestaltungen der Erfindung sind den Unteransprüchen entnehmbar.

Anhand der Figuren der beiliegenden Zeichnungen seien im folgenden ein bekannter Logikschaltkreis und Ausführungsbeispiele eines erfindungsgemäßen Logikschaltkreises näher beschrieben. Es zeigen:

Fig. 1 einen bekannten UND-Schaltkreis;

Fig. 2 einen grundsätzlichen Aufbau eines erfindungsgemäßen Logikschaltkreises;

Fig. 3 ein Schaltungsdiagramm eines bei dem erfindungsgemäßen Logikschaltkreis verwendeten Schaltelementes;

Fig. 4A und 4B Schaltungsdiagramme für das letzte
Schaltelement innerhalb der Kette bei dem
erfindungsgemäßen Logikschaltkreis; und

Fig. 5 ein weiteres Ausführungsbeispiel eines erfindungsgemäßen Logikschaltkreises.

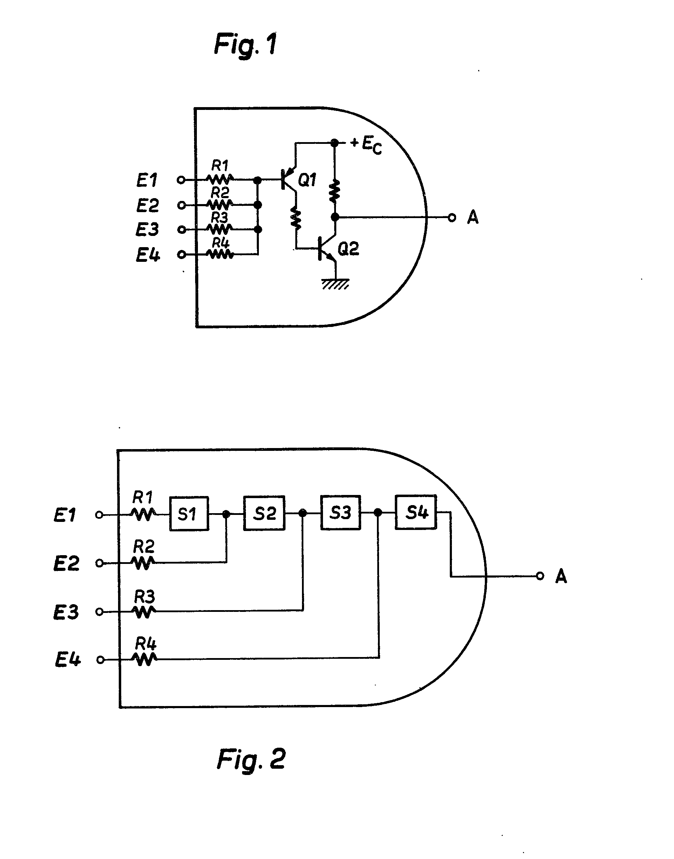

Fig. 1 zeigt ein bekanntes UND-Gatter mit 4 Eingängen E1,
E2, E3 und E4, die über 4 Eingangswiderstände R1, R2, R3
und R4 auf die Basis eines Eingangsstufentransistors Q1
geführt sind. Ein Ausgangsstufentransistor Q2 gibt einen
"1"-Pegel an seinem Ausgang A aus, wenn alle Eingangssignale E1, E2, E3 und E4 den "1"-Pegel aufweisen und er
gibt an diesem Ausgang einen "0"-Pegel aus, wenn irgendeines der Eingangssignale den "0"-Pegel besitzt.

Wird bei diesem Schaltkreis beispielsweise der Widerstand
R3 defekt, so nimmt das Ausgangssignal A den "1"-Pegel ein,
obgleich an dem Eingang E3 ein "0"-Pegel anliegt, sofern
die anderen Eingänge E1, E2 und E4 den "1"-Pegel aufweisen. Wenn es daher beispielsweise die Aufgabe der Logikschaltung gemäß Fig. 1 ist, an dem Ausgang A nur dann den
hohen Pegel zu erzeugen, wenn der Eingang E1 von dem niedrigen auf den hohen Pegel umschaltet und die weiteren Eingänge den hohen Pegel aufweisen, so kann diese Schaltungsanordnung ihre Funktion nicht erfüllen.

Der in Fig. 2 dargestellte Logikschaltkreis ist so aufgebaut, daß er auch in diesem Fall die gewünschte logische
Verknüpfung noch ausführt. Dieser Schaltkreis besteht aus
Schaltstufen S1, S2, S3 und S4, die einerseits hintereinandergeschaltet sind und zum anderen über Widerstände R1, R2,
R3 und R4 an entsprechende Eingänge E1, E2, E3 und E4 angeschlossen sind. Die Schaltstufen S1 bis S4 besitzen die
Eigenschaft, in Abhängigkeit von dem Pegel der angelegten
Eingangssignale ihren Ausgang kurzzuschließen bzw. einen
offenen Ausgang zu liefern. Am Ausgang A der letzten Schaltstufe S4 wird das Ausgangssignal des Logikschaltkreises abgenommen.

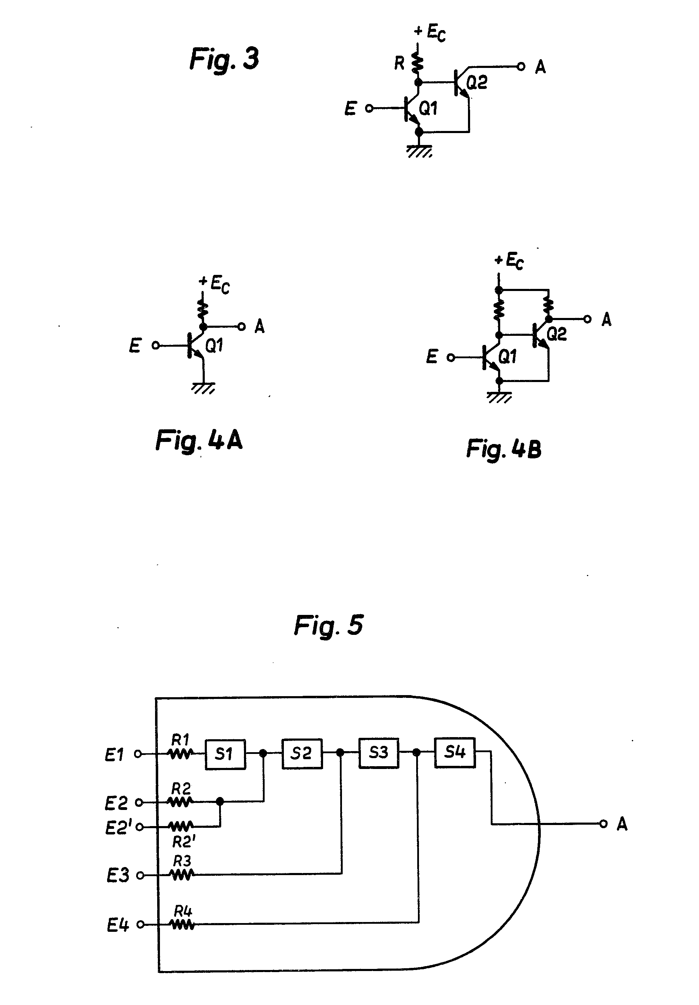

Fig. 3 zeigt ein konkretes Ausführungsbeispiel einer der
Schaltstufen S1 bis S4. Jede Schaltstufe weist einen ersten
Transistor Q1 auf, dem an seiner Basis das Eingangssignal
zugeführt wird. Der Kollektor des Transistors Q1 ist über
einen Widerstand R einerseits an eine Betriebsspannungsquelle $E_C$ angeschlossen und andererseits mit der Basis
eines zweiten Transistors Q2 verbunden. Der Kollektor des
zweiten Transistors Q2 ist nicht über den Widerstand R
an die Betriebsspannungsquelle $E_C$ angeschlossen; vielmehr
bildet dieser direkt den Ausgang der Schaltstufe. Die
Emitter beider Transistoren Q1 und Q2 sind an Masse gelegt.
Die so aufgebaute Schaltstufe weist einen offenen aufgetrennten Ausgang auf, wenn das Eingangssignal den hohen
Pegel besitzt und sie weist einen kurzgeschlossenen Ausgang auf, wenn das Eingangssignal den niedrigen Pegel besitzt.

Der Schaltkreis gemäß Fig. 2 erzeugt somit einen offenen
Ausgang A, wenn die Eingangssignale E1, E2, E3 und E4 alle
den hohen Pegel besitzen und sie erzeugt einen kurzgeschlossenen Ausgang A, wenn irgendeines dieser Eingangssignale den niedrigen Pegel besitzt.

Die Schaltstufe S2 weist einen kurzgeschlossenen Ausgang
auf, unabhängig von dem Ausgang der Schaltstufe S1, wenn
das Eingangssignal E2 den niedrigen Pegel besitzt. Das
durch den kurzgeschlossenen Ausgang erzeugte Signal mit
niedrigem Pegel wird daher der Schaltstufe S3 unabhängig
davon zugeführt, ob das Eingangssignal E3 den hohen oder
niedrigen Pegel aufweist. In gleicher Weise erzeugt die
Schaltstufe S4 auf Grund ihres kurzgeschlossenen Ausganges
den niedrigen Pegel, so daß der Logikschaltkreis am Ausgang A insgesamt den niedrigen Pegel ausgibt.

Es sei nun die Funktion des Logikschaltkreises betrachtet, wenn dieser eine Störung aufweist.

Zunächst sei der Fall betrachtet, wenn ein Eingang aufgetrennt ist. Beispielsweise sei angenommen, daß auf Grund eines defekten Widerstandes R3 das Eingangssignal E3 nicht mehr zugeführt werden kann. Somit weist das dem Eingang der Schaltstufe S3 zugeführte Eingangssignal entweder den niedrigen oder den hohen Pegel entsprechend einer kurzgeschlossenen oder offenen vorhergehenden Stufe auf, was von der UND-Verknüpfung der Eingangssignale E1 und E2 abhängt. In beiden Fällen gelangt jedoch der Transistor Q1 in der Schaltstufe S3 nicht in den leitenden Zustand. Die Schaltstufe S3 erzeugt daher am Ausgang einen Kurzschluß, wodurch auch die nachfolgende Stufe und somit der Logikschaltkreis insgesamt an seinem Ausgang A das niedrige Potential ausgibt.

Jetzt sei der Fall betrachtet, in welchem auf Grund von Defekten der Transistor Q1 durchgeschaltet und der Transistor Q2 ausgeschaltet bleibt. Wenn irgendeine der Schaltstufen in dieser Weise defekt ist, so erzeugt sie einen kurzgeschlossenen Ausgang und der Logikschaltkreis erzeugt insgesamt an seinem Ausgang A auf Grund eines kurzgeschlossenen Ausganges das Signal mit niedrigem Pegel.

Schließlich sei der Fall betrachtet, bei dem auf Grund von Defekten der Transistor Q1 durchgeschaltet und der Transistor Q2 ausgeschaltet bleibt. In diesem Fall weist die defekte Schaltstufe unabhängig von dem Eingangssignal einen offenen Ausgang auf. Dies bedeutet, daß das Eingangssignal der defekten Schaltstufe von dem Ausgang des Logikschaltkreises isoliert wird.

Der Ausgang A des Logikschaltkreises wird daher nur in der gewünschten Weise von dem kurzgeschlossenen Zustand in den offenen Zustand gebracht, wenn der Logikschaltkreis funktionsfähig ist und das Eingangssignal E1 bei einem hohen Pegel der Eingangssignale E2, E3 und E4 den niedrigen Pegel aufweist. Im Falle eines Defektes behält der Logikschaltkreis den kurzgeschlossenen bzw. den offenen Ausgang bei. Die gewünschte logische Funktion am Ausgang A wird daher nur erhalten, wenn die vorbestimmte Logik durch die Eingangssignale erfüllt wird und der Logikschaltkreis nicht defekt ist.

Bei der vorstehenden Beschreibung wurde davon ausgegangen, daß die Schaltstufe S4, d.h. die Endstufe ebenso aufgebaut war, wie die anderen Schaltstufen. Die End-Schaltstufe kann jedoch so aufgebaut sein, daß sie bezüglich ihres Eingangssignales eine Invertierung vornimmt, wie dies durch die Schaltstufe gemäß Fig. 4A geschieht. In diesem Fall erzeugt der gesamte Logikschaltkreis eine NAND-Verknüpfung. Die Schaltstufe S4 kann ferner so aufgebaut sein, daß sie bezüglich des Eingangssignales keine Invertierung erzeugt, anstatt des offenen Ausganges ein Ausgangssignal mit hohen Pegel erzeugt, wie dies in Fig. 4B dargestellt ist. In diesem Fall erzeugt der gesamte Logikschaltkreis wiederum eine UND-Verknüpfung. Es können ferner mehrere Eingangssignale einer bestimmten Schaltstufe parallel zugeführt werden, was beispielsweise in Fig. 5 durch die Eingänge E2 und E2' der zweiten Schaltstufe S2 veranschaulicht ist.

Es sei ferner darauf verwiesen, daß die Verwirklichung der Schaltstufe gemäß Fig. 3 nicht die einzige Möglichkeit darstellt; vielmehr sind verschiedene Schaltkreise denkbar, die auf Grund eines Eingangssignales mit hohem oder niedrigem Pegel einen kurzgeschlossenen oder offenen Ausgang erzeugen.

Bei dem erfindungsgemäßen Logikschaltkreis, wie er vorstehend beschrieben wurde, können den Eingangssignalen Prioritäten zugeordnet werden, wobei diese Eingangssignale durch Verknüpfung gemäß einer bestimmten logischen Funktion das Ausgangssignal ergeben. Es ist daher möglich, bezüglich der Eingangssignale ein Ausgangssignal mit einer gewünschten logischen Funktion zu erzielen, während jeder mögliche Fehler des Schaltkreises im voraus berücksichtigt wird, um einen fehlerhaften Betrieb der Logik auszuschließen.

Patentansprüche:

1. Logikschaltkreis zur Verknüpfung mehrerer Eingangssignale (E1,E2,E3,E4) und zur Abgabe eines Ausgangssignales (A) auf Grund der verknüpften Eingangssignale,
g e k e n n z e i c h n e t   d u r c h   mehrere
hintereinander geschaltete von jeweils einem Eingangssignal (E1,E2,E3,E4) und einer vorangehenden Schaltstufe
beaufschlagte Schaltstufen (S1,S2,S3,S4), die in Abhängigkeit von ihrer Beaufschlagung einen kurzgeschlossenen oder offenen Ausgang aufweisen.

2. Logikschaltkreis nach Anspruch 1,   d a d u r c h
g e k e n n z e i c h n e t ,   daß die Schaltstufen
(S1,S2,S3,S4) bei einem "0"-Signal am Eingang einen
kurzgeschlossenen Ausgang und bei einem "1"-Signal am
Eingang einen offenen Ausgang aufweisen.

3. Logikschaltkreis nach Anspruch 2,   d a d u r c h
g e k e n n z e i c h n e t ,   daß zur Realisierung
einer NAND-Funktion die letzte Schaltstufe (S4) gegenüber den vorangehenden Schaltstufen (S1,S2,S3) eine invertierende Funktion aufweist.

4. Logikschaltkreis nach Anspruch 2,   d a d u r c h
g e k e n n z e i c h n e t ,   daß jede Schaltstufe
(S2 bis S4) einen ersten und einen zweiten Transistor
(Q1 und Q2) aufweist, wobei die Basis des ersten Transistors (Q1) an das Eingangssignal (E) und den Ausgang
der vorangehenden Schaltstufe (S) angeschlossen ist,
die Emitter beider Transistoren (Q1,Q2) an Masse gelegt
sind, der Kollektor des ersten Transistors (Q1) einmal
über einen Widerstand (R) an die Betriebsspannung ($+E_C$)
gelegt und zum anderen direkt mit der Basis des zweiten
Transistors (Q2) verbunden ist und wobei der Kollektor
des zweiten Transistors (Q2) den Ausgang der Schaltstufe
(S) bildet.

0032746

5. Logikschaltkreis nach Anspruch 1 oder einem der folgenden, d a d u r c h   g e k e n n z e i c h n e t ,
   daß eine oder mehrere Schaltstufen (S1 bis S4) von mehr
   als 2 Eingangssignalen (E2,E2') beaufschlagt sind.

**Fig. 1**

**Fig. 2**

Honeywe

Fig. 3

$+E_C$

R

Q2

A

E

Q1

Fig. 4A

$+E_C$

A

E

Q1

Fig. 4B

$+E_C$

A

Q2

E

Q1

Fig. 5

E1

R1

S1

S2

S3

S4

E2

R2

E2'

R2'

E3

R3

E4

R4

A

Honeywel

| | EINSCHLÄGIGE DOKUMENTE | | | KLASSIFIKATION DER ANMELDUNG (Int. Cl.³) |
| --- | --- | --- | --- | --- |
| Kategorie | Kennzeichnung des Dokuments mit Angabe, soweit erforderlich, der maßgeblichen Teile | | betrifft Anspruch | |
| X | US - A - 3 614 591 (J.L. BROWN) <br> * Zusammenfassung; Spalte 3, Zeile 21 bis Spalte 4, Zeile 61; Fig., Positionen Q2, ... Q5 * <br> -- | | 1 | H 03 K 19/003 <br> H 03 K 19/20 |
| X | ELEKTRIE, Nr. 1, 1968 <br> H. SCHULZE "Wege zu fehlersicheren elektronischen Steuerungssystemen mit binärer Wirkung" <br> Seiten 15 bis 18 <br> * Anschnitt 5; Bild 8 * <br> ---- | | 1,5 | |

**RECHERCHIERTE SACHGEBIETE (Int. Cl.³)**

G 05 B 9/02
H 03 K 19/00
H 03 K 19/003
H 03 K 19/007
H 03 K 19/08
H 03 K 19/20

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. | | |
| --- | --- | --- | --- |
| Recherchenort | Abschlußdatum der Recherche | Prüfer | |
| Berlin | 10-04-1981 | ARENDT | |